# EUROPEAN PATENT APPLICATION

(11) **EP 0 868 013 A1**
(43) Date of publication of application: **30.09.1998**
(21) Application number: 98104257.5
(22) Date of filing: 10.03.1998
(51) Int. Cl.: H02M 1/00, H01L 25/11, H02M 7/72, H02M 1/14

(54) **A voltage source converter (VSC) with low self inductance**

(30) Priority: 24.03.1997 SE 9701069
(71) Applicant: ASEA BROWN BOVERI AB, 721 78 Västeras (SE)
(72) Inventor: Blidberg, Ingemar, 771 43 Ludvika (SE); Ekwall, Olle, 771 43 Ludvika (SE)
(74) Representative: Olsson, Jan

(57) **Abstract**

A VSC converter has each current valve (7, 10) of a phase leg (4) formed by a plurality of units (22) of semiconductor elements and rectifying members piled on top of each other in at least one stack. The phase leg is constructed according to the ribbon cable principle with the phase leg formed by such stacks arranged side by side in pairs at small distances (d) and running to and fro and having a cooling plate (23) of electrically conducting material arranged between and connected in series with each unit in the stacks.

## Description

### FIELD OF THE INVENTION AND PRIOR ART

The present invention relates to a VSC converter for converting direct voltage into alternating voltage or direct voltage and conversely and which has at least one phase leg with two current valves connected in series, which consist of at least one semiconductor element of turn-off type and one rectifying member connected in anti-parallel therewith, in which a point on the phase leg between said valves is intended to be connected to a phase of a direct or alternating voltage network and the opposite ends of the phase leg are intended to be connected to a pole conductor each of a direct voltage network.

Such a VSC converter for connection between a direct voltage network and an alternating voltage network has recently become known through the thesis "PWM" and control of two and three level High Power Voltage Source Converters" by Anders Lindberg, Kungliga Tekniska Högskolan, Stockholm, 1995, in which thesis a plant for transmitting electric power through a direct voltage network for High Voltage Direct Current (HVDC) while utilizing such a converter is described. Before the issuance of said thesis plants for transmitting electric power through a direct voltage network for High Voltage Direct Current have been based upon the use of line-commutated CSC (Current Source Converter) converters in stations for power transmission. By the development of IGBTs (Insulated Gate Bipolar Transistor = bipolar transistor having an insulated gate) for high voltage applications and the suitability to connect them in series in valves in converters, since they may easily be turned on and turned off simultaneously, VSC (Voltage Source Converter) converters for forced commutation have now instead become an alternative, and this type of transmission of electric power between a direct voltage network for High Voltage Direct Current being voltage-stiff therethrough and alternating voltage networks connected thereto offers several important advantages with respect to the use of line-commutated CSCs in HVDC, of which it may be mentioned that the consumption of active and reactive power may be controlled independently of each other and there is no risk of commutation failures in the converter and by that no risk of transmission of commutation failures between different HVDC links, which may take place in line-commutated CSC. Furthermore, there is a possibility to feed a weak alternating voltage network or a network without a generation of its own (a dead alternating voltage network). Further advantages are also there.

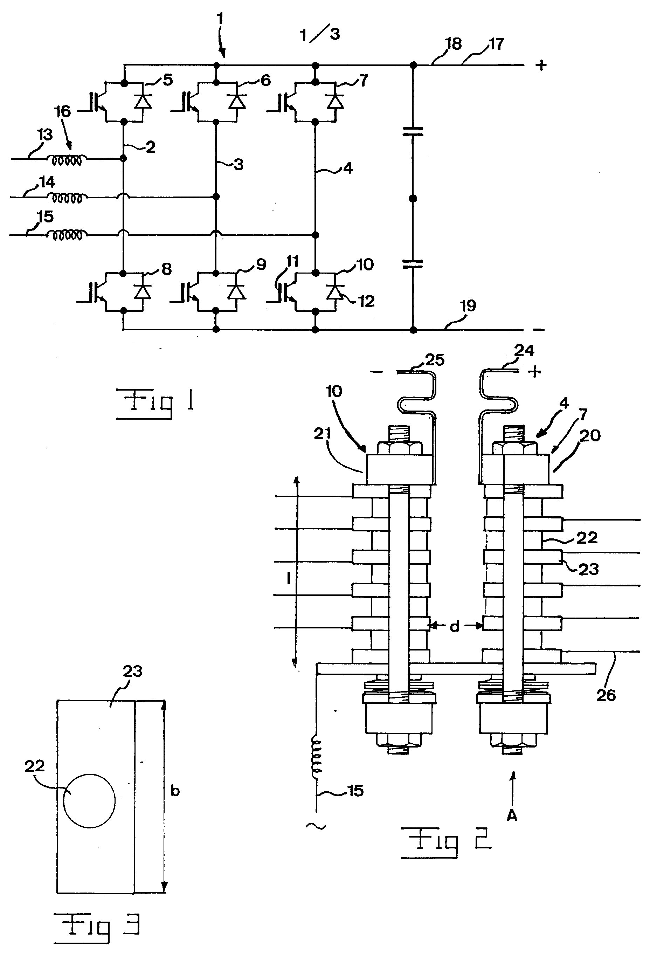

The invention is not restricted to this application, but the converter may just as well be intended for conversion of direct voltage into direct voltage in a DC/DC converter, in which then only one phase is present. "Networks" is also to be given a wide meaning, and it has not to be any such in the real meaning of this word. However, the problem of the invention will now be illuminated for exactly this application, although the problem is in common for all conceivable applications falling within the scope of the invention. In the use of a converter of the type defined in the introduction instead of a current-stiff CSC converter a totally new problem being not there for the latter arises, which will now be explained with reference to Fig 1, which shows a VSC converter 1 having three phase legs 2, 3, 4 with two current valves 5-10 each, each consisting of at least one semiconductor element of turn-off type, such as an IGBT 11, and a rectifying member in the form of a diode 12 connected in anti-parallel therewith. The phase legs are connected to a phase 13, 14, 15 each of a three-phase alternating voltage network 16. The opposite ends of the converter are connected to a direct voltage network 17 having a positive pole conductor 18 and a negative pole conductor 19. Thus, the converter is formed by a so-called 6-pulse bridge. If we now consider for example the phase 15 and assume that the semiconductor element 11 belonging to the current valve 10 is turned on and a current flows from the alternating voltage network through this semiconductor element and to the direct voltage network, a turning off of the semiconductor element 11 of the current valve 10 will cause the current to firstly continue from the phase 15 in the direction towards the direct voltage network, but now through the diode of the current valve 7. The commutation times are short and comparatively large time differential coefficients of the current occurs, which makes it desirable to lower the inductance in the commutation circuit, i.e. in the phase leg and the line connected between the two poles of the direct voltage network with capacitors for defining the direct voltage, to such a low level as possible so as to avoid unnecessarily high overvoltages and by that losses in said commutations.

### SUMMARY OF THE INVENTION

The object of the present invention is to provide a VSC converter of the type defined in the introduction, in which the problem mentioned above has been solved in a satisfying manner.

This object is according to the invention obtained by forming each current valve in such a converter by a plurality of units of semiconductor elements of turn-off type and rectifying members piled on top of each other in at least one stack, and by the fact that the phase leg is constructed according to the ribbon cable principle with the phase leg formed by such stacks running to and fro in pairs and arranged side by side at small distances and with a cooling plate of electrically conducting material arranged between and connected in series with each unit in the stacks.

By in this way utilize the so-called ribbon cable principle in this totally new application the inductance of the commutation circuit, more exactly of said phase leg, may be lowered to very low levels, so that said losses may be reduced to a low acceptable level. By piling said units of semiconductor elements of turn-off type and rectifying members on top of each other in a stack a short conducting distance for the current through a certain number of such units is obtained, which reduces the inductance, since this is proportional to said length. Furthermore, by in this way bring the current in such stacks belonging to the same pair to run in different directions it is obtained that the inductance is lowered by said ribbon cable effect, in which the inductance is substantially proportional to said distance between the stacks of such a pair. It is pointed out that "cooling plate" also comprises the case in which no cooling medium or the like is supplied for draining heat form such a plate, but cooling takes place simply by the fact that the plate absorbs heat and emits it to a surrounding medium, such as air. An arrangement of such cooling plates also makes it possible to arrange said units closer, i.e. to pile them with intermediate cooling plates so that the inductance may be reduced.

According to a preferred embodiment of the invention the plates have a large extension in the direction substantially perpendicular to a line interconnecting stacks arranged side by side. Since the inductance of such a pair of stacks in this case will be inversely proportional to the extension of the stacks in the direction substantially perpendicular to a line interconnecting stacks arranged side by side, the inductance may be reduced substantially through such a design of the cooling plates.

According to another preferred embodiment of the invention that side of each stack that is turned towards one side of the other stack belonging to the same pair is free from control members and other equipment so as to allow a determination of said distance only by the requirement of a minimum electrical free distance. By ensuring that all such additional equipment, such as control members, voltage dividers and cooling tubes, are placed in the way mentioned it is only the electric voltage between stacks located side by side and the voltage withstanding capability of the components included therein that are restricting for how small the distance between the two stacks may be made and by that how low the inductance can be. It is emphasized that except for a low inductance of the commutation circuit also a compact construction of the converter with a small demand of place is obtained by such a structure.

According to another preferred embodiment of the invention one said pair of stacks has parts placed side by side at a larger distance therebetween than other such parts of a stack pair placed side by side having a lower voltage therebetween than the voltage between the parts first mentioned. By letting the voltage present between the stacks in different points in this way determine the distance between the stacks in these points a lower inductance may be obtained than should the part of the stack pair having the highest voltage between the stacks be that one that determines the distance between the stacks along the entire extension thereof.

According to another preferred embodiment of the invention, which constitutes a further development of the embodiment last mentioned, said parts having different mutual distances are formed by a division of each stack into consecutive substacks with a mutual distance step-wisely changed in the transition therebetween. Such a realisation of different distances depending upon different voltages between different parts of the stacks may sometimes be preferred from the manufacturing and mounting technical point of view. It appears here that "stack" in this context is to be given a wide meaning and also comprises the case in which it may be divided into so-called sub-stacks, which are arranged according to lines displaced laterally with respect to each other.

According to another preferred embodiment of the invention, which constitutes an alternative to the preceding embodiment, the two stacks belonging to the same pair are mutually inclined, so that said distance increases linearly from one end thereof to the other. The smallest possible distance between the two stacks along the entire length thereof with respect to the electrical free distance required is in this way obtained.

According to another preferred embodiment of the invention the distance between the two current valves belonging to the same phase leg increases in the direction away from said point for the phase connection thereof. The voltage between two current valves belonging to the same phase leg increases in said direction, so that it is advantageous to increase the distance between the current valves in this direction therethrough.

According to another preferred embodiment of the invention each current valve of a phase leg is formed by one said stack and the stacks belonging to the same pair are intended to be connected to a pole conductor each at adjacent ends opposite to the ends for connection to a phase of a direct or alternating voltage network. This is a way being advantageous from the inductance and space saving point of view to form the phase leg of the converter, in which, accordingly, with respect to what is shown in Fig 1 discussed above the phase leg is bent back in the mid point between the two current valves.

According to another preferred embodiment of the invention each current valve of a phase leg is formed by one or more pairs of said stacks. This embodiment is advantageous in the case that a comparatively great number of said units of semiconductor elements and rectifying members have to be included in each current valve for enabling to hold a high voltage, since it may be problematical to obtain a stable construction with very long stacks. A low inductance of the phase leg is in this way in such a case still obtained.

According to another preferred embodiment of the invention the converter has a plurality of phase legs for connection to a plurality of phases of an alternating voltage network, and adjacent phase legs have a connection in common to a pole conductor of a direct voltage network. Such a physical arrangement of the different phase legs makes it possible to obtain a compact construction of the converter by the fact that the phase legs are located close to each other where they from the voltage point of view may be this, and also keeping the inductance low through short conducting lengths.

According to another preferred embodiment of the invention the number of phase legs is three and arranged side by side with the two outer phase legs provided with a said connection to a pole conductor each in common with the mid phase leg and these two connections in common are to different pole conductors of a direct voltage network. It is in this way possible to obtain a zig-zag-like extension of the different valves and a compact construction of the converter while respecting electrical free distances required.

According to another preferred embodiment of the invention the converter comprises means for suspending the stacks in a frame. "Frame" is here to be given a wide meaning and comprises each type of rigid or fixed base, such as for example a ceiling in a building. The current valves may by such a suspension of the stacks be arranged without other forces thereupon than the gravity force, and they will be comparatively insensitive to vibrations of the ground, such as earthquakes, primarily when they are suspended in a ceiling of a building.

According to another preferred embodiment of the invention the converter is intended to be connected to a direct voltage network for High Voltage Direct Current (HVDC). A series connection of a comparatively great number, well as much as thirty, of said units is required so as to form a current valve, so that the invention is particularly well suited for exactly this application.

Further advantages as well as advantageous features of the invention will appear from the following description and the other dependent claims.

### BRIEF DESCRIPTION OF THE DRAWINGS

With reference to the appended drawings, below follows a description of preferred embodiments of the invention cited as examples.

In the drawings:
- Fig 1: is a schematic diagram illustrating the structure of a VSC converter of the type according to the invention,
- Fig 2: is a detailed view of a phase leg of a converter according to a first preferred embodiment of the invention,
- Fig 3: is a sectioned view of a unit of semiconductor element and rectifying member as well as a cooling plate in the direction of the arrow A in Fig 2,
- Fig 4: is a simplified view of a phase leg of a converter according to a second preferred embodiment of the invention,
- Fig 5: is a very simplified sketch illustrating a possible design of a phase leg of a converter according to a third preferred embodiment of the invention,
- Fig 6: is a view of a phase leg of a converter according to a fourth preferred embodiment of the invention,
- Fig 7: is a view of a phase leg of a converter according to a fifth preferred embodiment of the invention,
- Fig 8: is a very simplified view of a converter having three phase legs according to a sixth preferred embodiment of the invention, and
- Fig 9: is a view in the direction of the arrow B in Fig 8 of a current valve of the converter according to Fig 8.

### DETAILED DESCRIPTION OF PREFERRED EMBODIMENTS OF THE INVENTION

Fig 1 has already been discussed above, and it may here be noted that it illustrates schematically the structure of a VSC converter connected between a direct voltage network for High Voltage Direct Current (HVDC = High Voltage Direct Current) and a three-phase alternating voltage network. Each phase leg of the converter has two so-called current valves, which consist of units of breakers 11 of turn-on and turnoff type connected in series, preferably in the form of IGBTs, and rectifying members connected in anti-parallel therewith, i.e. members being conducting in one direction and blocking in the opposite direction, in the form of diodes 12. A great number of such units and by that IGBTs may be connected in series in one single valve so as to be turned on and turned off simultaneously so as to function as one single breaker, wherethrough the voltage across the valve is distributed among the different breakers connected in series. The control of the breakers takes place through pulse width modulation (PWM). The inductance problems present in such a converter have been carefully disclosed in the introduction of the description, and a part of a very great number of embodiments of converters according to the invention within the scope of the present invention and parts of such converters will now be described with reference in order to Figs 2-9.

It is illustrated in Fig 2 how a phase leg 4 of a converter is constructed according to a first preferred embodiment of the invention according to the ribbon cable principle with the phase leg formed by stacks 20, 21 running to and fro, located side by side at a small distance d and forming a current valve each, said stacks being formed by a plurality of units 22 of semiconductor elements and rectifying members piled onto each other and a cooling plate 23 of electrically conducting material, preferably aluminium, arranged between and connected in series with each unit 22. It is illustrated in Fig 3 that the cooling plates 23 have a large extension b in the direction substantially perpendicular to a line interconnecting stacks arranged side by side, so that the phase leg similar to a ribbon cable is formed by a comparatively flat and wide element running in one direction and an identical element running back at a short distance from the first one in the opposite direction. Large usually means in this context that the extension in that direction is clearly larger than that of the units, preferably more than twice of the extension of the latter ones. A very low inductance of the phase leg is in this way obtained, which is also proportional to the length l of a stack and is reduced even more through said close piling. More exactly, the following formula is with a certain approximation valid for the inductance L:$\text{L = µ ·} \frac{\text{d}}{\text{b}} \text{· l}$ in which µ is the magnetic permeability. Through the ribbon cable-like structure of the phase leg of the converter shown in Fig 2 an inductance of this phase leg being several orders of magnitude lower than the inductance of a freely located conductor of the corresponding length may be obtained.

With respect to the embodiment according to Fig 2 and 3 it may be added that the two pole connections 24, 25 to the plus and minus pole conductor, respectively, of the phase leg are located at the same end of the phase leg, and connections of additional equipment, such as driving means for the IGBTs, voltage dividers and cooling tubes to the cooling plates 23, are indicated by 26, in which these are so located that they do not interfere with the determination of the distance d.

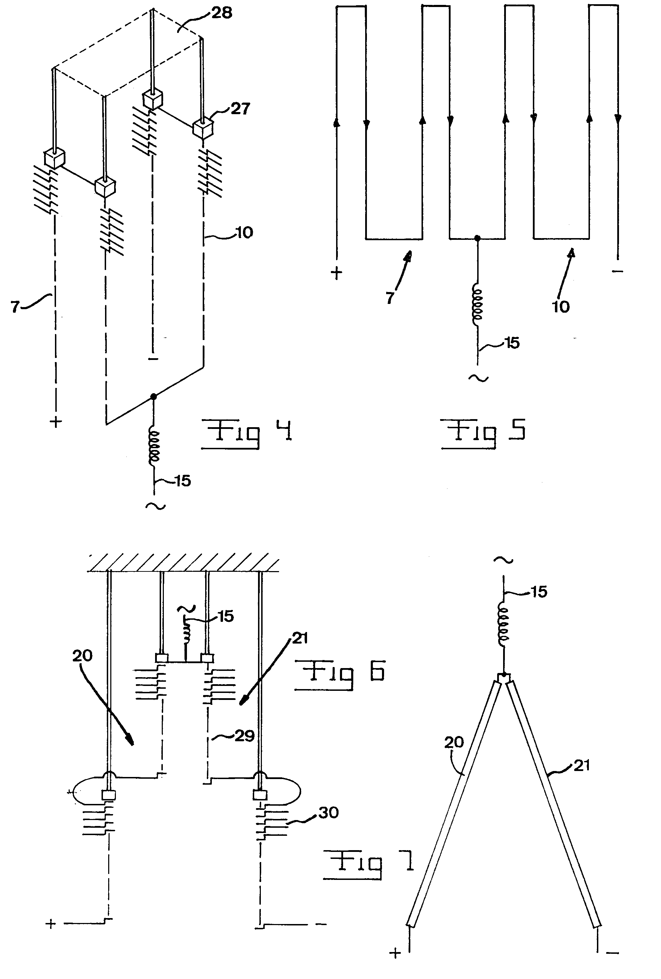

The structure of a phase leg of a converter according to a second preferred embodiment of the invention is schematically illustrated in Fig 4, and in this embodiment a pair of stacks having a construction according to the ribbon cable principle forms a separate current valve 7, 10 of the phase leg. It is here also illustrated how the converter may be provided with means 27 for suspending the stacks in the ceiling 28 of the building.

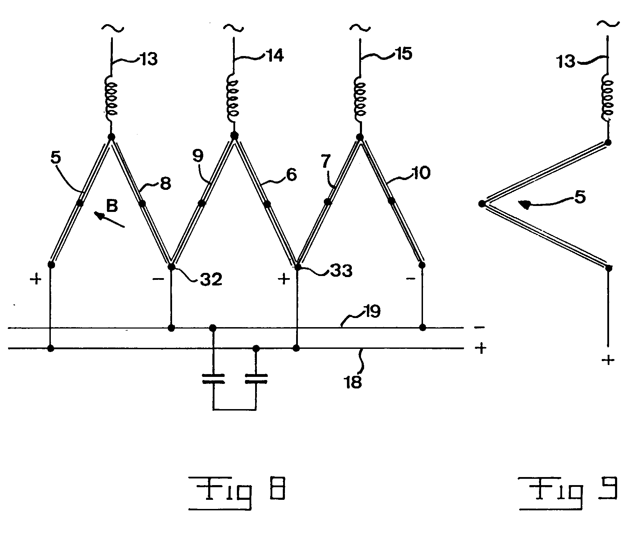

It is very schematically illustrated in Fig 5 what a phase leg may look like in a converter according to a third preferred embodiment of the invention, in which two pairs of stacks constructed according to the ribbon cable principle form each current valve, and this structure may be advantageous when very high voltages are to be held by the current valve, which means a requirement of a series connection of a great number of semiconductor elements of turn-off type.

It is shown in Fig 6 how a phase leg may be constructed in a converter according to a fourth preferred embodiment of the invention by dividing each stack 20, 21 forming a current valve into two sub-stacks 29, 30 for obtaining a distance between the stacks varying stepwisely, so that this distance may be made smaller where the voltage between adjacent stack parts is lower than it is at the end 31, where it is highest.

It is illustrated in Fig 7 how a phase leg of a converter according to a fifth preferred embodiment of the invention may be designed so as to obtain the goal of the embodiment shown in Fig 6, but a linear increase of the distance between the two stacks towards the end where the voltage therebetween is the highest takes place here.

The structure of a converter having three phase legs according to a sixth preferred embodiment of the invention is very schematically illustrated in Fig 8 and 9, in which adjacent current valves are as seen from above arranged in an angle with respect to each other, so that the distance thereof is the largest where the voltage therebetween is the highest, while the corresponding design is there for each pair of stacks forming a current valve, but in planes extending perpendicularly to the drawing plane in Fig 8. The phase legs are arranged side by side with the two outer phase legs 2, 4 provided with a connection 32, 33 each to a pole conductor 19 and 18, respectively, of the direct voltage network in common with the mid phase leg 3. A compact construction is obtained by this.

The invention is of course not in any way restricted to the preferred embodiments described above, but many possibilities to modifications thereof would be apparent for a man skilled in the art without departing from the basic idea of the invention, such as this is defined in the patent claims.

It may for example be mentioned that the number of stacks of the phase leg may differ from that shown in the figures, the angles made by the stacks belonging to the same pair may be different, the number of sub-stacks in stacks having a distance changing stepwisely may be another, and so on.

It may also be mentioned that the VSC converter may be of different types, such as two-level converter, NPC converter, etc.

It is also emphasized that "cooling plate" is to be given a wide meaning in the sense that "cooling plate" is intended to comprise an amount of plate-like structures, in which opposite flat sides do not necessarily have to be completely in parallel with each other, but they may have for example bulgings, groovings or the like.

## Claims

1. A VSC converter for converting direct voltage into alternating voltage or direct voltage and conversely and which has at least one phase leg (2-4) with two current valves (5-10) connected in series, which consist of at least one semiconductor element (11) of turn-off type and one rectifying member (12) connected in anti-parallel therewith, in which a point on the phase leg between said valves is intended to be connected to a phase (13-15) of a direct or alternating voltage network and the opposite ends of the phase leg are intended to be connected to a pole conductor (18, 19) each of a direct voltage network, **characterized** in that each current valve is formed by a plurality of units (22) of semiconductor elements of turn-off type and rectifying members piled on top of each other in at least one stack (20, 21), and that the phase leg is constructed according to the ribbon cable principle with the phase leg formed by such stacks running to and fro in pairs and arranged side by side at small distances (d) and with a cooling plate (23) of electrically conducting material arranged between and connected in series with each unit in the stacks.

2. A converter according to claim 1, **characterized** in that the plates have a large extension (b) in the direction substantially perpendicular to a line interconnecting stacks running beside each other.

3. A converter according to claim 2, **characterized** in that that side of each stack (20, 21) that is turned towards one side of the other stack belonging to the same pair is free from control members and other equipment (26) so as to allow a determination of said distance only by the requirement of a minimum electrical free distance.

4. A converter according to any of claims 1-3, **characterized** in that a said pair of stacks (20, 21) has parts of two such stacks placed side by side at a larger distance therebetween than other such parts of a stack pair placed side by side having a lower voltage therebetween than the voltage between the parts first mentioned.

5. A converter according to claim 4, **charaterized** in that said parts having different mutual distances are formed by a division of each stack (20, 21) into consecutive sub-stacks (29, 30) with a mutual distance step-wisely changed in the transition therebetween.

6. A converter according to claim 4, **charaterized** in that the two stacks (20, 21) belonging to the same pair are mutually inclined, so that said distance increases linearly from one end thereof to the other.

7. A converter according to any of claims 1-6**, characterized** in that the distance between the two current valves belonging to the same phase leg increases in the direction away from said point for the phase connection thereof.

8. A converter according to any of claims 1-7, **characterized** in that each current valve in a phase leg is formed by one said stack (20, 21) and that the stacks belonging to the same pair are intended to be connected to a pole conductor (18, 19) each at adjacent ends opposite to the ends for connection to a phase (13-15) of a direct or alternating voltage network.

9. A converter according to any of claims 1-7, **characterized** in that each current valve (5-10) of a phase leg is formed by one or more pairs of said stacks.

10. A converter according to any of claims 1-9, **characterized** in that it has a plurality of phase legs (2-4) for connection to a plurality of phases (13-15) of an alternating voltage network, and that adjacent phase legs have a connection in common to a pole conductor of a direct voltage network.

11. A converter according to claim 10, **characterized** in that the number of phase legs (2-4) is three and they are arranged side by side with the two outer phase legs (2, 4) provided with a said connection to a pole conductor (18, 19) each in common with the mid phase leg (3) and that these two connections in common are to different pole conductors of a direct voltage network.

12. A converter according to any of claims 1-11, **characterized** in that it comprises means (27) for suspending the stacks in a frame (28).

13. A converter according to any of claims 1-12, **characterized** in that the cooling plates (23) are of aluminium.

14. A converter according to any of claims 1-13, **characterized** in that it is intended to be connected to a direct voltage network (17) for High Voltage Direct Current (HVDC).
